Europäisches Patentamt

European Patent Office

Office européen des brevets

(19)

(11) EP 0 734 120 B1

(12) **EUROPEAN PATENT SPECIFICATION**

(45) Date of publication and mention
of the grant of the patent:
**05.04.2000 Bulletin 2000/14**

(51) Int Cl.⁷: **H03H 9/02**, H03H 9/25

(21) Application number: **96104549.9**

(22) Date of filing: **21.03.1996**

(54) **Surface acoustic wave resonator filter**

Akustisches Oberflächenwellenresonatorfilter

Filtre-résonateur à ondes acoustiques de surface

(84) Designated Contracting States:
**DE FR GB**

(30) Priority: **23.03.1995 JP 6439695**

(43) Date of publication of application:
**25.09.1996 Bulletin 1996/39**

(73) Proprietor: **MURATA MANUFACTURING CO., LTD.
Nagaokakyo-shi Kyoto-fu 226 (JP)**

(72) Inventors:
• **Shimoe, Kazunobu
Nagaokakyo-shi, Kyoto-fu (JP)**
• **Hiraishi, Akira
Nagaokakyo-shi, Kyoto-fu (JP)**

(74) Representative: **Schoppe, Fritz, Dipl.-Ing.
Schoppe, Zimmermann & Stöckeler
Patentanwälte
Postfach 71 08 67
81458 München (DE)**

(56) References cited:
• **PATENT ABSTRACTS OF JAPAN vol. 013, no.
099 (E-724), 8 March 1989 & JP-A-63 272215
(NIPPON SEIKI CO LTD), 9 November 1988,**
• **JOURNAL OF APPLIED PHYSICS, vol. 50, no. 3,
March 1979, NEW YORK, US, pages 1360-1369,
XP002007596 T. E. PARKER ET AL.:
"Temperature-Compensated
Surface-Acoustic-Wave devices with SiO2 Film
Overlays"**

## Description

### BACKGROUND OF THE INVENTION

#### 1. Field of the Invention

The present invention relates to a surface acoustic wave resonator filter having a plurality of interdigital transducers and reflectors located on a piezoelectric substrate.

#### 2. Description of the Related Art

Various communication devices recently developed utilize a surface acoustic wave filter and, especially, there has recently been a trend toward use of intermediate frequency (IF) stages for digital communication system which requires a compact filter having high selectivity, a wide pass band width, and flat group delay characteristics. There is a well known conventional compact surface acoustic wave filter having small insertion loss and a wide pass band width which is a longitudinally-coupled resonator filter including a plurality of interdigital transducers (IDTs) located close to each other on a $LiTaO_3$ substrate of a 36° Y-cut X-propagation type and reflectors provided on both sides of the IDTs.

However, in a conventional resonator filter utilizing a $LiTaO_3$ substrate of a 36° Y-cut X-propagation type, the temperature coefficient at frequency is about - 35 ppm/°C and, for example, the frequency changes in a range as large as ±1750 ppm for temperatures in a range of room temperatur ±50°C. This has resulted in the effective pass band width during actual use of such a filter being so narrow that selectivity in the vicinity of the pass band (attenuation in the adjacent channel) is insufficient. There has been another problem in that, for a reason associated with the magnitude of the reflection coefficient, it is difficult to make such a filter sufficiently compact because the filter requires reflectors having a relatively large number of reflection electrode fingers to trap a sufficient amount of energy.

The document Journal of applied physics, Vol 50, № 3, March 1979, New York, US, [PARKER et al] Pages 1360-1369 discloses a $LiTaO_3$ SAW device with a $SiO_2$ layer deposited there upon.

### SUMMARY OF THE INVENTION

The preferred embodiments of the present invention are defined by the appended claims and provide an inexpensive and compact surface acoustic wave resonator filter having excellent temperature characteristics, high performance, and a wide pass band width by limiting a thickness of electrodes of a plurality of IDTs and reflectors, a thickness of a $SiO_2$ film, and the number of pairs of electrode fingers of the IDTs to be within preferred ranges.

In order to achieve the above-mentioned advantages, according to a first aspect of the preferred embodiments of the present invention, a surface acoustic wave resonator filter includes: a $LiTaO_3$ substrate of a 36° Y-cut X-propagation type; a plurality of IDTs located close to each other on the $LiTaO_3$ substrate; reflectors located on both sides of the plurality of IDTs; and a $SiO_2$ film arranged so that the $SiO_2$ film covers the IDTs and reflectors. Electrodes of the IDTs and reflectors are preferably made of aluminum or an alloy mainly composed of aluminum. An electrode thickness ratio $T/\lambda$ and a $SiO_2$ film thickness ratio $H/\lambda$ are preferably set to satisfy the following ranges:

$$2.6\ \% \leq T/\lambda \leq 4.8\ \%$$

$$22\ \% \leq H/\lambda \leq 38\ \%$$

where T represents the thickness of the electrodes of the IDTs and reflectors; H represents the thickness of the $SiO_2$ film; and $\lambda$ represents the wavelength of a surface acoustic wave, and is twice as long as a reflector electrode pitch.

A surface acoustic wave resonator filter according to a second aspect of the preferred embodiments of the present invention is characterized in that a plurality of stages each constituted by the resonator structure including the IDTs and reflectors according to the first aspect of the preferred embodiments of the present invention are located on a $LiTaO_3$ substrate of 36° Y-cut X-propagation type and in that the stages are cascaded.

According to a third aspect of the preferred embodiments of the present invention, in a surface acoustic wave resonator filter according to the first or second aspect of the preferred embodiments of the present invention, the $SiO_2$ film is preferably formed using an RF magnetron sputtering process.

According to a fourth aspect of the preferred embodiments of the present invention, in a surface acoustic wave resonator filter according to any one of the first, second and third aspects of the preferred embodiments of the present invention, the total number Nt of the pairs of electrode fingers of the IDTs in one stage is preferably set to be within the range $14 \leq Nt \leq 68$.

According to a fifth aspect of the preferred embodiments of the present invention, in a surface acoustic wave resonator filter according to any one of the first, second, third, and fourth aspects of the preferred embodiments of the present invention, the $SiO_2$ film thickness ratio $H/\lambda$ is preferably set to be within the range $26\ \% \leq H/\lambda \leq 36\ \%$.

According to the first aspect of the preferred embodiments of the present invention, by limiting the electrode thickness ratio $T/\lambda$ and the $SiO_2$ film thickness ratio $H/\lambda$ to the preferred ranges, a compact surface acoustic wave resonator filter having low insertion loss and good temperature characteristics can be provided as described later in detail.

According to the second aspect of the preferred embodiments of the present invention, by connecting a multiplicity of such stages, a filter having higher selectivity can be obtained.

According to the third aspect of the preferred embodiments of the present invention, the formation of the $SiO_2$ film using an RF magnetron sputtering process improves productivity on a mass production basis.

According to the fourth aspect of the preferred embodiments of the present invention, by limiting the number of the pairs of the electrode fingers of the IDTs to a preferred range, it is possible to maintain a required pass band width and to reduce pass-band ripple.

According to the fifth aspect of the preferred embodiments of the present invention, by limiting the $SiO_2$ film thickness ratio $H/\lambda$ to a preferred range, the temperature characteristics of frequency can be improved further.

Other features and advantages of the present invention will become apparent from the follwing description of the preferred embodiments of the invention which are shown in the accompanying drawings.

BRIEF DESCRIPTION OF THE DRAWINGS

Fig. 1(a)   is a plan view of a surface acoustic wave resonator filter according to a first preferred embodiment of the present invention.

Fig. 1(b)   is a sectional view taken along the line X-X in Fig. 1.

Fig. 2   is a plan view of a surface acoustic wave resonator filter according to a second preferred embodiment of the present invention.

Fig. 3   illustrates the relationship between a $SiO_2$ film thickness ratio $H/\lambda$ and the reflection coefficient of one electrode finger using an electrode thickness ratio $T/\lambda$ as a parameter, which has been obtained from an experiment in accordance with the preferred embodiments of the present invention.

Fig. 4   illustrates the relationship between the electrode thickness ratio $T/\lambda$ and insertion loss obtained from an experiment in accordance with the preferred embodiments of the present invention.

Fig. 5   illustrates the relationship between the

$SiO_2$ film thickness ratio $H/\lambda$ and a temperature coefficient of frequency using the electrode thickness ratio $T/\lambda$ as a parameter, which has been obtained from an experiment in accordance with the preferred embodiments of the present invention.

Fig. 6   illustrates the relationship between the total number Nt of pairs of electrode fingers of IDTs, a pass-band ripple, and a 3 dB relative band width from a peak loss, which has been obtained from an experiment in accordance with the preferred embodiments of the present invention.

Fig. 7   shows an example of filter characteristics of a surface acoustic wave resonator filter according to another preferred embodiment of the present invention.

Fig. 8   shows changes in center frequency of a surface acoustic wave resonator filter according to a preferred embodiment of the present invention and a conventional surface acoustic wave resonator filter relative to temperature.

DETAILED DESCRIPTION OF PREFERRED EMBODIMENTS

The inventors of the preferred embodiments of the present invention studied the possibility of improving temperature characteristics of frequency by forming a $SiO_2$ film on IDTs and reflectors using an RF magnetron sputtering process suitable for mass production and discovered that, by limiting the thickness of the aluminum electrodes and $SiO_2$ film and the like to preferred ranges, temperature characteristics of frequency can be improved, and a compact size can be achieved as a result of a reduction in the number of the electrode fingers of the reflectors.

The present invention will now be described with reference to the accompanying drawings showing preferred embodiments thereof. A dotted area in the plan views referred to hereinafter indicates an area covered by a $SiO_2$ film.

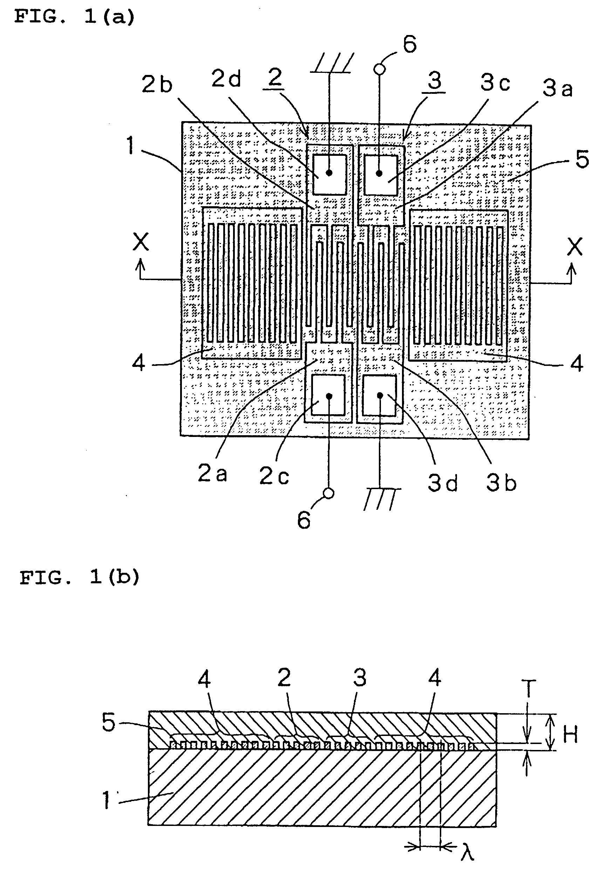

A configuration of a surface acoustic wave resonator filter according to a first preferred embodiment of the invention is shown in Fig. 1(a) and Fig. 1(b). Fig. 1 (a) is a plan view showing a basic structure which is the minimum unit of a surface acoustic wave resonator filter according to the preferred embodiment of the present invention. Fig. 1(b) is a sectional view taken along the line X-X in Fig. 1(a).

As shown in Figs. 1(a) and 1(b), in the surface acoustic wave resonator filter of the present preferred embodiment, IDTs 2 and 3 each having a respective pair of comb-shaped electrodes 2a and 2b and a respective pair of comb-shaped electrodes 3a and 3b whose electrode fingers are interdigitated with each other are provided close to each other on a LiTaO$_3$ substrate 1 of a 36° Y-cut X-propagation type, and reflectors 4 each constituted by a plurality of reflective electrode fingers are located on both sides of the IDTs 2 and 3. Further, a SiO$_2$ film 5 is formed on the LiTaO$_3$ substrate of a 36° Y-cut X-propagation so that the film 5 covers the IDTs 2 and 3 and reflectors 4.

The comb-shaped electrodes 2a, 2b, 3a, and 3b, respectively have exposed electrode portions 2c, 2d, 3c, and 3d for inputting and outputting signals at connection portions thereof. The exposed electrode portions 2c and 3c are connected to input/output terminals 6, and the exposed electrode portions 2d and 3d are connected to ground.

The surface acoustic wave resonator filter of the preferred embodiments of the present invention is preferably produced as described in the following paragraphs.

First, a film made of aluminum or an aluminum alloy containing about 1 % by weight of copper is formed on the LiTaO$_3$ substrate 1 of a 36° Y-cut X-propagation type by means of evaporation, sputtering, or the like. Thereafter, the film is patterned using photolithography or the like to form the IDTs 2 and 3 and reflectors 4. Then, the SiO$_2$ film 5 is formed by means of RF magnetron sputtering or the like so that the SiO$_2$ film covers the IDTs 2 and 3 and reflectors 4.

The exposed electrode portions 2c, 2d, 3c, and 3d are formed, for example, by removing part of the SiO$_2$ film 5 using an ion etching process performed in CF$_4$ plasma or by using a mask during the formation of the SiO$_2$ film 5.

A multiplicity of the surface acoustic wave resonator filters as described above are formed on a LiTaO$_3$ mother board (wafer) of a 36° Y-cut X-propagation type, and individual filters are manufactured by cutting and separating them using a dicing machine or the like. In Fig. 1(b), T represents the thickness of the electrodes of the IDTs 2 and 3 and reflectors 4; H represents the thickness of the SiO$_2$ film; and λ represents the wavelength of a surface acoustic wave and is twice as long as a reflector electrode pitch.

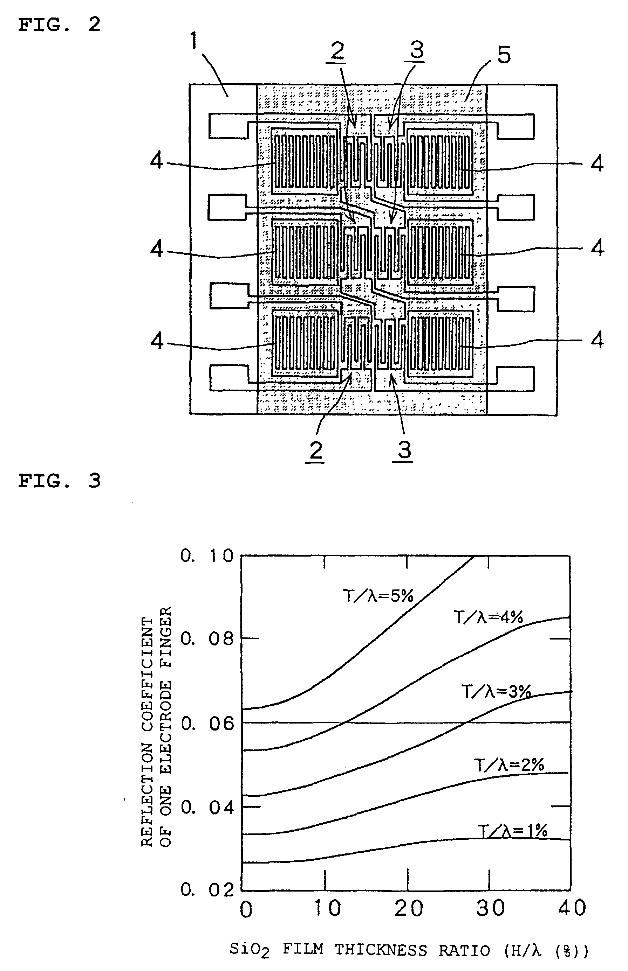

Fig. 2 shows a configuration of a surface acoustic wave resonator filter according to a second preferred embodiment of the invention. Fig. 2 is a plan view of a surface acoustic wave resonator filter having a plurality of the resonators having the structure shown in Fig. 1 formed thereon. As shown in Fig. 2, the surface acoustic wave resonator filter of the present preferred embodiment is configured by providing three surface acoustic wave resonator filters including the IDTs 2 and 3 and reflectors 4 as shown in Fig. 1 on a LiTaO$_3$ substrate 1 of a 36° Y-cut X-propagation type in parallel with each other and by cascading those surface acoustic wave resonator filters. The configurations of the IDTs and reflectors are substantially the same as those in Fig.

1 and therefore will not be described here.

By providing such a multiplicity of cascaded stages of surface acoustic wave resonators each including IDTs and reflectors, a surface acoustic wave resonator filter can be obtained which exhibits high selectivity as a result of great attenuation outside the pass band.

A description will now be made of the reasons for the design conditions as set forth above for a surface acoustic wave resonator filter according to the preferred embodiments of the present invention based on the results of experiments made on many samples produced by varying the electrode thickness, the SiO$_2$ film thickness, the pitch of the electrode fingers, the number of the pairs of electrode fingers, etc.

Fig. 3 shows changes in the reflection coefficient of one electrode finger of an IDT or reflector relative to a SiO$_2$ film thickness ratio H/λ using an electrode thickness ratio T/λ as a parameter.

As shown in Fig. 3, the reflection coefficient of one electrode finger depends on the thickness H of the SiO$_2$ film or the thickness T of the electrode and linearly increases with the thickness in both cases.

In the case of a conventional LiTaO$_3$ substrate of a 36° Y-cut X- propagation type (having no SiO$_2$ film), in order to obtain desired characteristics (insertion loss) by trapping the energy of a surface acoustic wave in the resonator filter sufficiently, for example, about 50 electrode fingers are required for the reflector when the electrode thickness ratio T/λ is 4.5 %. In this case (T/ λ = 4.5 % and H/ λ = 0), as shown in Fig. 3, the reflection coefficient of one electrode finger is 0.06.

It is essential to reduce the number of the electrode fingers of the reflector to provide a compact surface acoustic wave resonator filter. In order to reduce the number of the electrode fingers of the reflector to a value less than 50 unlike the prior art, the reflection coefficient of one electrode finger must be at least greater than 0.06. However, a large SiO$_2$ film thickness results in an increase in the time required for forming the film, which reduces productivity. In addition, it results in stress being generated in the substrate which can cause the breakage of the substrate during or after assembly and can produce cracks in the electrode films and SiO$_2$ film. Therefore, a SiO$_2$ film thickness ratio H/λ must be 40 % or less for practical use.

Fig. 3 shows that the electrode thickness ratio T/λ must be 2.6 % or more so that the reflection coefficient of one electrode finger can be above 0.06 for a SiO$_2$ film thickness ratio H/λ in a practical range from 0 to 40 %.

It is therefore required to set the electrode thickness ratio T/λ at 2.6 % or more to provide a compact device.

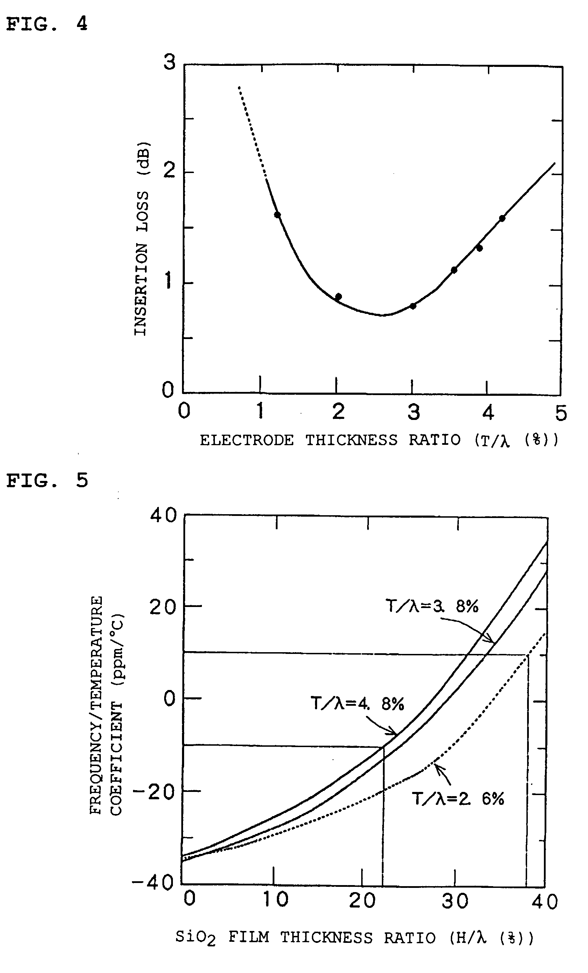

Fig. 4 illustrates the relationship between the electrode thickness ratio H/λ and the minimum insertion loss of a filter when the SiO$_2$ film thickness ratio H/λ is 29.5%.

As shown in Fig. 4, to an electrode film thickness ratio H/ λ of about 2.5 %, the insertion loss decreases as the electrode film thickness ratio H/λ is increased because the energy of the surface acoustic wave is confined in the resonator filter by the reflectors. However, when about 2.5 % is exceeded, the insertion loss increases as the electrode film thickness ratio H/ λ is increased. This is thought to be attributable to an increase in the loss associated with mode conversion from the surface acoustic wave to a bulk wave at the electrode.

Since a filter used in an IF stage must have high selectivity in general, such a filter must have a configuration wherein a multiplicity of stages are cascaded as shown in Fig. 2. When three stages are cascaded as shown in Fig. 2, there will be insertion loss three times greater than that in a one-stage configuration. That is, the minimum insertion loss of a filter which is actually used is three times the insertion loss shown in Fig. 4.

Meanwhile, according to design techniques for transversal filters which are frequently used as wide band filters, the minimum insertion loss is a value which is the sum of a bidirectional loss of 6 dB and other kinds of loss. Therefore, according to the preferred embodiments of the present invention which are directed to the reduction of insertion loss, the target minimum insertion loss for the cascaded three stages is set at 6 dB. That is, the target is the area where the insertion loss is 2 dB or less in Fig. 4, and it will be understood that this can be achieved by setting the electrode thickness ratio T/ λ at 4.8 % or less. Further, in the case where the electrode thickness ratio T/λ is set at 4.3 % or less, the insertion loss can be reduced to 1.5 dB.

Fig. 5 illustrates the relationship between the $SiO_2$ thickness ratio H/λ and a temperature coefficient of frequency using the electrode thickness ratio T/λ as a parameter.

As shown in Fig. 5, the temperature coefficient of frequency depends not only on the $SiO_2$ film thickness H/λ but also on the electrode thickness ratio T/λ, and the $SiO_2$ film thickness ratio H/λ at which a zero temperature coefficient is obtained varies depending on the electrode thickness ratio T/λ.

The target in designing the temperature coefficient of frequency is set at one-third of that in the prior art, i.e., ±10 ppm/°C or less. Fig 5 shows that a temperature coefficient of frequency of ±10 ppm/°C or less can be obtained by setting the $SiO_2$ film thickness ratio H/λ in the range of 22 to 38 % with the electrode thickness ratio T/λ set in the range of 2.6 to 4.8 % as described above.

Further, the temperature coefficient of frequency can be set at ±5 ppm/°C or less which is equal or superior to the temperature coefficient of frequency of a surface acoustic wave filter utilizing a quartz substrate by setting the $SiO_2$ film thickness ratio H/λ in the range of 26 to 36 %. Since the temperature coefficient of frequency can be set at about 0 ppm/°C, it is more preferable that the $SiO_2$ film thickness ratio H/λ is set to be in the range of about 27 to 35 %.

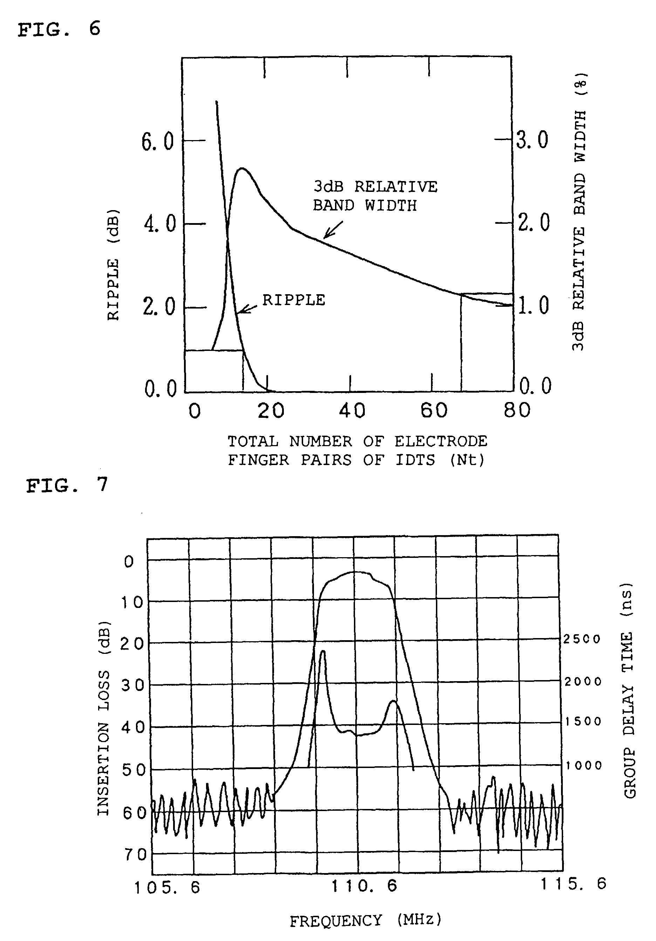

A description will now be made of the proper setting of the number of the pairs of the electrode fingers of IDTs to suppress a pass-band ripple and to obtain a required pass band width. Assuming that N represents the number of the pairs of the electrode fingers of each of the IDTs 2 and 3 in Fig. 1 and that Nt represents the total number of the pairs of the electrode fingers of those two IDTs (the total number of the electrode fingers), Fig. 6 illustrates changes in a pass-band ripple and a 3 dB relative band width when the total number Nt of the electrode finger pairs is varied.

For example, in the case of an IF filter to be used for the center frequency 110.6 MHz of a Digital European Cordless Telephone (DECT) system, the required pass band width is the nominal center frequency ±0.6 MHz or more, i.e., 1.2 MHz or more. A conventional surface acoustic wave resonator filter utilizing a $LiTaO_3$ of a 36° Y-cut X-propagation type must have a pass band width of 1.5 MHz or more when temperature characteristics of frequency and aging are considered. However, according to the preferred embodiments of the present invention wherein the temperature coefficient of frequency can be very small, a pass band width of 1.3 MHz and a relative band width of about 1.2 % do not result in any problem in actual use even if temperature characteristics of frequency and aging tolerance are considered. Further, a pass-band ripple must be 1 dB or less during actual use.

Fig. 6 shows that a 3 dB relative band width of 1.2 % or more and a pass-band ripple of 1 dB or less can be achieved by setting the total number of electrode finger pairs Nt and the number of the electrode finger pairs N (which is half of Nt) in the ranges of 14 to 68 and 7 to 34, respectively. The greater the number of the electrode finger pairs of the IDTs, the greater the insertion loss. However, it has been determined that the insertion loss is 2 dB or less when the total number of the electrode finger pairs Nt is at the maximum value of 68.

As described above, strict limitations are placed on design conditions in order to provide a surface acoustic wave resonator filter which has a temperature coefficient of frequency of ±10 ppm/°C or less, which can be made compact, and which has less loss and ripple by using a $LiTaO_3$ of a 36° Y-cut X-propagation type and by forming a $SiO_2$ film. The resultant design conditions can be summarized as follows.

(1) The electrode thickness ratio T/ λ is preferably within the rage 2.6 % ≤ H/λ ≤ 4.8 %.
(2) The $SiO_2$ film thickness ratio H/λ is preferably within the range 22 % ≤ H/λ ≤ 38 %, and even more preferably within the range of 26 % ≤ H/λ ≤ 36 %.
(3) The total number Nt of the electrode finger pairs of the IDTs is preferably within the range of 14 ≤ Nt ≤ 68.

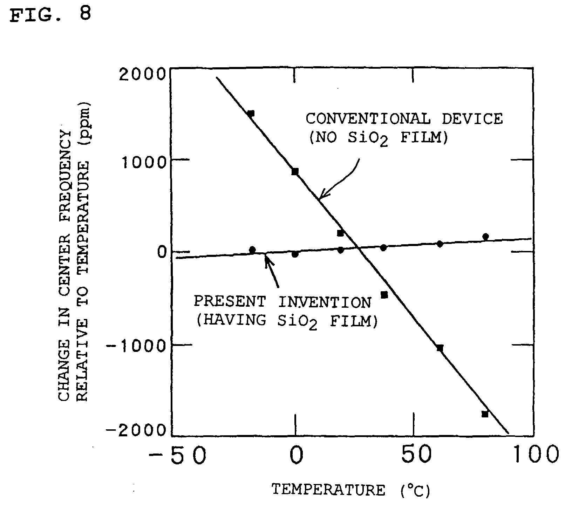

Fig. 7 shows an example of the characteristics of a surface acoustic wave resonator filter having a nominal center frequency of 110.6 MHz produced based on the results described above.

In the case, the surface acoustic wave resonator filter has a three-stage configuration as shown in Fig. 2 wherein the IDTs and reflectors are constituted by aluminum electrodes; the $SiO_2$ film is formed using an RF magnetron sputtering process; and the electrode thickness ratio $T/\lambda$, the $SiO_2$ film thickness ratio $H/\lambda$, and the total number of electrode finger pairs Nt are set at 3.7 %, 29.5 %, and 28, respectively.

The 3 dB pass band width is about 1.5 MHz, and a relative pass band width of 1.36 % has been obtained. Further, a very small temperature coefficient of frequency is obtained which allows the attenuation to be maintained at 46 dB or more at a frequency of 110.6 MHz $\pm$1.728 MHz that requires a great attenuation in a temperature range of room temperature$\pm$50°C. Further, the reflection coefficient of one electrode finger is measured at about 0.075.

Fig. 8 shows changes in center frequencies of a conventional surface acoustic wave resonator filter wherein no $SiO_2$ film is formed and the filter of the above-described preferred embodiment relative to temperature. Fig. 8 shows that the conventional surface acoustic wave resonator filter has a temperature coefficient of frequency of -35 ppm/°C while the filter of the above-described preferred embodiment has that of +0.6 ppm/°C. Thus, the change in the center frequency relative to temperature has been greatly improved.

In addition, the reflection coefficient of one electrode finger can be as great as about 0.075, which allows the number of the electrode fingers of the reflectors to be reduced from 50 to 40. Further, since the radiation conductance of the IDTs is increased, the number of the pairs of the electrode fingers of the IDTs can be reduced. This makes it possible to obtain a chip size as small as two-third of that in the prior art in terms of the area ratio and to provide a surface acoustic wave filter in a package having a size which is one-third of that of the prior art devices.

Although the above-described preferred embodiments are double-mode resonator filters utilizing a 0th order longitudinal mode and a 1st order longitudinal mode wherein two IDTs are formed between reflectors in the above-described preferred embodiments, the preferred embodiments of the present invention may be applied to a surface acoustic wave resonator filter in which three or more IDTs are formed between reflectors to encourage higher modes.

As described above, according to the preferred embodiments of the present invention, a compact surface acoustic wave resonator filter having good temperature characteristics, high performance, and a wide pass band width can be obtained by forming a $SiO_2$ film so that the $SiO_2$ film covers IDTs and reflectors formed on a $LiTaO_3$ substrate of a 36° Y-cut X-propagation type and by setting the thickness of the electrodes, the thickness of the $SiO_2$ film, and the total number of the pairs of electrode fingers in preferred ranges.

In addition, by forming the $SiO_2$ film using an RF magnetron sputtering process having high productivity, the cost for forming the $SiO_2$ film is reduced; the reduction in the chip size increases the number of chips obtained from one sheet of wafer by a factor of about 1.5; and the improvement on temperature characteristics improves the yield of the device, which reduces the material cost and improves productivity.

Although the present invention has been described in relation to particular preferred embodiments thereof, many other variations and modifications and other uses will become apparent to those skilled in the art. It is preferred, therefore, that the present invention be limited not by the specific disclosure herein, but only by the appended claims.

## Claims

1. A surface acoustic wave resonator filter comprising:

   a $LiTaO_3$ 36° Y-cut X-propagation substrate (1);

   a plurality of interdigital transducers, IDTs, (2, 3) located on said $LiTaO_3$ substrate (1);

   a plurality of reflectors (4) located on both sides of said plurality of IDTs (2, 3); and

   a $SiO_2$ film (5) arranged so that it covers said IDTs (2, 3) and said reflectors (4), wherein

   an electrode thickness ratio $T/\lambda$ and a $SiO_2$ film thickness ratio $H/\lambda$ are set to satisfy:

   $$2.6\ \% \leq T/\lambda \leq 4.8\ \%$$

   $$22\ \% \leq H/\lambda \leq 38\ \%$$

   where T represents a thickness of each of the electrodes of said IDTs (2, 3) and said reflectors (4); H represents a thickness of said $SiO_2$ film (5); and $\lambda$ represents a wavelength of a surface acoustic wave generated on said substrate (1), and is twice as long as a reflector electrode pitch.

2. A surface acoustic wave resonator filter according to claim 1 further comprising a plurality of stages each constituted by a plurality of said IDTs (2, 3) and reflectors (4) being located on said $LiTaO_3$ substrate (1) and wherein said stages are cascaded.

3. The surface acoustic wave resonator filter according to Claim 1 or 2, wherein said $SiO_2$ film (5) comprises a film formed using by an RF magnetron sputtering process.

4. The surface acoustic wave resonator filter according to one of Claims 1 to 3, wherein a total number Nt of the pairs of electrode fingers of said plurality of IDTs (2, 3) is set to satisfy $14 \leq Nt \leq 68$.

5. The surface acoustic wave resonator filter according to one of Claims 1 to 4, wherein the $SiO_2$ film thickness ratio $H/\lambda$ is set to satisfy $26 \% \leq H/\lambda \leq 36 \%$.

6. The surface acoustic wave resonator filter according to one of Claim 1 to 5, wherein the $SiO_2$ film thickness ratio $H/\lambda$ is set to satisfy $27 \% \leq H/\lambda \leq 35 \%$.

7. A method for producing a surface acoustic wave resonator filter, comprising the steps of:

forming a plurality of electrodes for forming interdigital transducers, IDTs, (2, 3) and reflectors (4) on a $LiTaO_3$ 36° Y-cut X-propagation substrate (1), wherein a thickness T of said plurality of electrodes and a wavelength $\lambda$ of a surface acoustic wave generated on said substrate (1) are set to satisfy $2.6 \% \leq T/\lambda \leq 4.8 \%$; and

forming a $SiO_2$ film (5) on said IDTs (2, 3) by an RF magnetron sputtering method, wherein a thickness H of said $SiO_2$ film (5) and said wavelength $\lambda$ are set to satisfy $22 \% \leq H/\lambda \leq 38 \%$.

8. A method according to claim 7, wherein the step of forming said plurality of electrodes includes the steps of:

forming a metal film on said substrate (1); and

pattering said metal film to form said IDTs (2, 3) having a total number Nt of pairs of electrode fingers, wherein said Nt is set to satisfy $14 \leq Nt \leq 68$.

**Patentansprüche**

1. Ein Akustikoberflächenwellen-Resonatorfilter mit folgenden Merkmalen:

einem $LiTaO_3$-36°-Y-Schnitt-X-Ausbreitungssubstrat (1);

einer Mehrzahl von Interdigitalwandlern, IDTs, (2, 3), die auf dem $LiTaO_3$-Substrat (1) ange-

ordnet sind;

einer Mehrzahl von Reflektoren (4), die auf beiden Seiten der Mehrzahl von IDTs (2, 3) angeordnet sind; und

einem $SiO_2$-Film (5), der derart angeordnet ist, daß er die IDTs (2, 3) und die Reflektoren (4) bedeckt, wobei

ein Elektrodendicke-Verhältnis $T/\lambda$ und ein $SiO_2$-Filmdicke-Verhältnis $H/\lambda$ derart eingestellt sind, daß gilt:

$$2{,}6\% \leq T/\lambda \leq 4{,}8\%$$

$$22\% \leq H/\lambda \leq 38\%$$

wobei T eine Dicke jeder der Elektroden der IDTs (2, 3) und der Reflektoren (4) darstellt; H eine Dicke des $SiO_2$-Films (5) darstellt; und $\lambda$ eine Wellenlänge einer akustischen Oberflächenwelle, die auf dem Substrat (1) erzeugt wird und die doppelt so lang wie ein Reflektorelektrodenabstand ist, darstellt.

2. Ein Akustikoberflächenwellen-Resonatorfilter nach Anspruch 1, das ferner eine Mehrzahl von Stufen aufweist, von denen jede durch eine Mehrzahl der IDTs (2, 3) und Reflektoren (4), die auf dem $LiTaO_3$-Substrat (1) angeordnet sind, gebildet ist, wobei die Stufen kaskadiert sind.

3. Das Akustikoberflächenwellen-Resonatorfilter nach Anspruch 1 oder 2, bei dem der $SiO_2$-Film (5) einen Film aufweist, der unter Verwendung eines HF-Magnetron-Sputterverfahrens gebildet ist.

4. Das Akustikoberflächenwellen-Resonatorfilter nach einem der Ansprüche 1 bis 3, bei dem eine Gesamtzahl Nt der Paare von Elektrodenfingern der Mehrzahl von IDTs (2, 3) derart eingestellt ist, daß gilt: $14 \leq Nt \leq 68$.

5. Das Akustikoberflächenwellen-Resonatorfilter nach einem der Ansprüche 1 bis 4, bei dem das $SiO_2$-Filmdicke-Verhältnis $H/\lambda$ derart eingestellt ist, daß gilt: $26\% \leq H/\lambda \leq 36\%$.

6. Das Akustikoberflächenwellen-Resonatorfilter nach einem der Ansprüche 1 bis 5, bei dem das $SiO_2$-Filmdickeverhältnis $H/\lambda$ derart eingestellt ist, daß gilt: $27\% \leq H/\lambda \leq 35\%$.

7. Ein Verfahren zum Herstellen eines Akustikoberflächenwellen-Resonatorfilters, mit folgenden Schritten:

Erzeugen einer Mehrzahl von Elektroden zum Bilden von Interdigitalwandlern, IDTs, (2, 3) und Reflektoren (4) auf einem $LiTaO_3$-36°-Y-Schnitt-X-Ausbreitungssubstrat (1), wobei eine Dicke T der Mehrzahl von Elektroden und eine Wellenlänge $\lambda$ einer akustischen Oberflächenwelle, die auf dem Substrat (1) erzeugt wird, derart eingestellt sind, daß gilt: $2,6\% \leq T/\lambda \leq 4,8\%$; und

Bilden eines $SiO_2$-Films (5) auf den IDTs (2, 3) durch ein HF-Magnetron-Sputterverfahren, wobei eine Dicke H des $SiO_2$-Films (5) und die Wellenlänge $\lambda$ derart eingestellt sind, daß gilt: $22\% \leq H/\lambda \leq 38\%$.

**8.** Ein Verfahren nach Anspruch 7, bei dem der Schritt des Erzeugens der Mehrzahl von Elektroden folgende Schritte aufweist:

Erzeugen eines Metallfilms auf dem Substrat (1); und

Strukturieren des Metallfilms, um die IDTs (2, 3) mit einer Gesamtzahl Nt von Paaren von Elektrodenfingern zu erzeugen, wobei Nt derart eingestellt ist, daß gilt: $14 \leq Nt \leq 68$.

**Revendications**

**1.** Filtre résonateur à ondes acoustiques de surface comprenant :

un substrat de propagation X de découpe Y à 36° de $LiTaO_3$ (1) ;
une pluralité de transducteurs interdigitaux, IDT, (2, 3) situés sur ledit substrat de $LiTaO_3$ (1) ;
une pluralité de réflecteurs (4) situés des deux côtés de ladite pluralité d'IDT (2, 3) ; et
un film de $SiO_2$ (5) disposé pour qu'il couvre lesdits IDT (2, 3) et lesdits réflecteurs (4), où un rapport d'épaisseur d'électrode $T/\lambda$ et un rapport d'épaisseur de film de $SiO_2$ $H/\lambda$ soit réglés pour satisfaire :

$$2,6\% \leq T/\lambda \leq 4,8\%$$

$$22\% \leq H/\lambda \leq 38\%$$

où T représente une épaisseur de chacune des électrodes desdits IDT (2, 3) et lesdits réflecteurs (4), H représente une épaisseur du-

dit film de $SiO_2$ (5) ; et $\lambda$ représente une longueur d'onde d'une onde acoustique de surface générée sur ledit substrat (1), et est deux fois aussi longue qu'un pas d'électrode de réflecteur.

**2.** Filtre résonateur à ondes acoustiques de surface selon la revendication 1 comprenant en outre une pluralité d'étages constitués chacun par une pluralité desdits IDT (2, 3) et des réflecteurs (4) étant situés sur ledit substrat de $LiTaO_3$ (1) et où lesdits étages sont en cascade.

**3.** Filtre résonateur à ondes acoustiques de surface selon la revendication 1 ou 2, dans lequel ledit film de $SiO_2$ (5) comprend un film formé en utilisant un traitement de pulvérisation sous vide de magnétron RF.

**4.** Filtre résonateur à ondes acoustiques de surface selon l'une quelconque des revendications 1 à 3, dans lequel le nombre total Nt de paires de doigts d'électrode de ladite pluralité de IDT (2, 3) est réglé pour satisfaire $14 \leq Nt \leq 68$.

**5.** Filtre résonateur à ondes acoustiques de surface selon l'une quelconque des revendications 1 à 4, dans lequel ledit rapport d'épaisseur de film de $SiO_2$ $H/\lambda$ est réglé pour satisfaire $26\% \leq H/\lambda \leq 36\%$.

**6.** Filtre résonateur à ondes acoustiques de surface selon l'une quelconque des revendications 1 à 5, dans lequel ledit rapport d'épaisseur de film de $SiO_2$ $H/\lambda$ est réglé pour satisfaire $27\% \leq H/\lambda \leq 35\%$.

**7.** Procédé pour produire un filtre résonateur à ondes acoustiques de surface, comprenant les étapes de :

formation d'une pluralité d'électrode pour former les transducteurs interdigitaux, IDT, (2, 3) et des réflecteurs (4) sur un substrat de propagation X de découpe Y à 36° de $LiTaO_3$ (1), où une épaisseur T de ladite pluralité des électrodes et une longueur d'ondes $\lambda$ d'une onde acoustique de surface générée sur ledit substrat (1) sont réglés pour satisfaire $2,6\% \leq T/\lambda \leq 4,8\%$ ; et
formation d'un film de $SiO_2$ (5) sur lesdits IDT (2, 3) par un procédé de pulvérisation de magnétron RF, dans lequel une épaisseur H dudit film de $SiO_2$ (5) et ladite longueur d'onde $\lambda$ sont réglés pour satisfaire $22\% \leq H/\lambda \leq 38\%$.

**8.** Procédé selon la revendication 7, dans lequel l'étape de formation de ladite pluralité d'électrode comprend des étapes de :

formation d'un film de métal sur ledit substrat (1) ; et

formation de motifs sur ledit film de métal pour former les IDT (2, 3) ayant un nombre total Nt de paires de doigts d'électrode, où ledit Nt est réglé pour satisfaire 14 ≤ Nt ≤ 68.

FIG. 1(a)

FIG. 1(b)

FIG. 2

FIG. 3

EP 0 734 120 B1

FIG. 4

INSERTION LOSS (dB) vs ELECTRODE THICKNESS RATIO (T/λ (%))

FIG. 5

FREQUENCY/TEMPERATURE COEFFICIENT (ppm/°C) vs SiO₂ FILM THICKNESS RATIO (H/λ (%))

T/λ=3. 8%

T/λ=4. 8%

T/λ=2. 6%

12

FIG. 6

3dB RELATIVE
BAND WIDTH

RIPPLE

TOTAL NUMBER OF ELECTRODE
FINGER PAIRS OF IDTS (Nt)

FIG. 7

FREQUENCY (MHz)

FIG. 8